# EUROPEAN PATENT APPLICATION

(11) **EP 1 548 846 A2**
(43) Date of publication of application: **29.06.2005**
(21) Application number: 04027342.7
(22) Date of filing: 17.11.2004
(51) Int. Cl.: H01L 31/042, H01L 31/048

(54) **Solar celll module edge face sealing member and solar cell module employing same**

(30) Priority: 28.11.2003 JP 2003399730; 17.02.2004 JP 2004040233
(71) Applicant: Sharp Kabushiki Kaisha, Osaka-shi, Osaka 545-8522 (JP)
(72) Inventor: Yoshida, Hiroyuki, Nara 636-0053 (JP); Umemoto, Akimasa, Germantown, Tennessee 38138 (US); Fukuda, Yukio, Kashiba-shi, Nara 639-0223 (JP); Suzuki, Yuji, Shiki-gun, Nara 636-0312 (JP)
(74) Representative: Müller - Hoffmann & Partner

(57) **Abstract**

Edge face sealing member(s) may be roughly c-shaped in cross-section, may be frame-like in shape and formed in more or less parallel fashion with respect to outer shape(s) of solar cell module body or bodies, may comprise upper sealing region(s) abutting front surface(s) of solar cell module body or bodies, may further comprise lower sealing region(s) abutting back surface(s) of solar cell module body or bodies, and may further comprise side sealing region(s) abutting edge face(s) of solar cell module body or bodies. Furthermore, sealing region(s) may be roughly c-shaped in cross-section; may comprise upper sealing region(s) abutting front surface(s) of solar cell module body or bodies, lower sealing region(s) abutting back surface(s) of solar cell module body or bodies, and side sealing region(s) abutting edge face(s) of solar cell module body or bodies; may be of two-layer construction; and outer layer(s) may be hard, hardness(es) of inner layer(s) being less than that of outer layer(s); as a result of which there may be intimate contact even with nonflat and/or nonsmooth glass surface(s), permitting sealing.

## Description

### BACKGROUND OF INVENTION

This application claims priority to Patent Application No. 2003-399730 filed in Japan on 28 November 2003 and to Patent Application No. 2004-40233 filed in Japan on 17 February 2004, the content of both of which is incorporated herein by reference in its entirety.

The present invention relates to an edge face sealing member for a solar cell module capable of being installed on roof portions of residential buildings or the like, and in particular, pertains to an improvement for ensuring watertightness between solar cell module body or bodies and frame body or bodies supporting same.

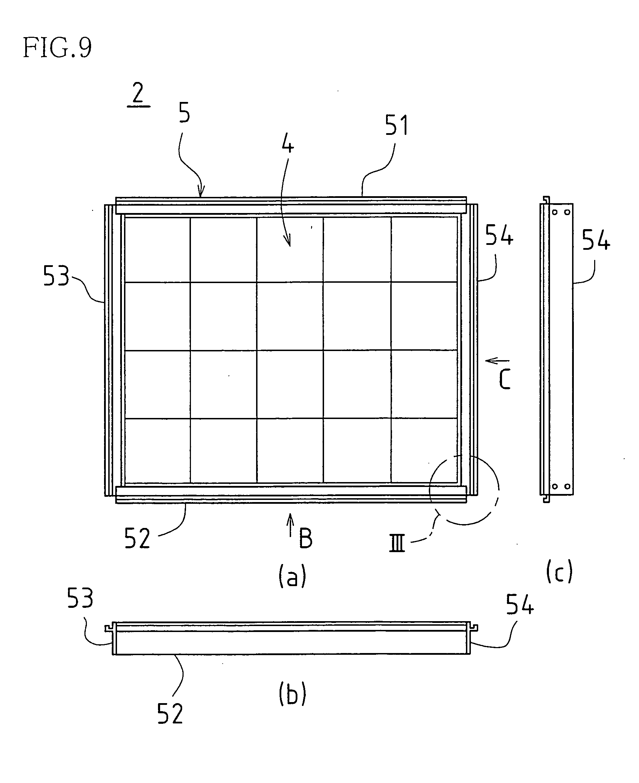

As shown in FIG. 9, a solar cell module might typically comprise solar cell module body or bodies 4 and frame body or bodies 5. FIG. 9 (a) is a plan view of solar cell module 2; FIG. 9 (b) indicating the view from arrow B at FIG. 9 (a), and FIG. 9 (c) indicating the view from arrow C at FIG. 9 (a).

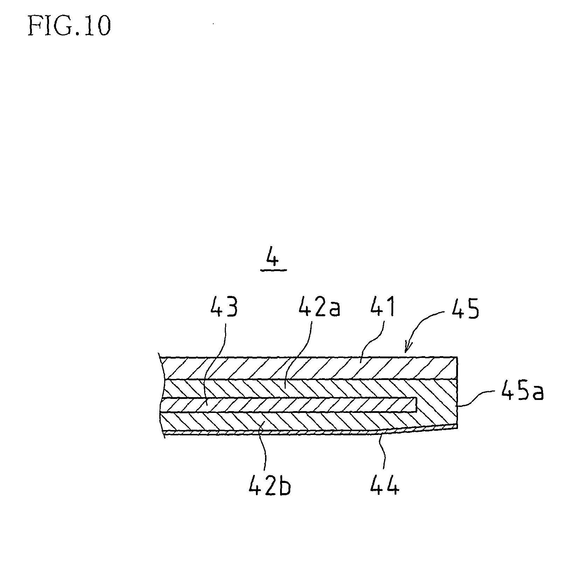

The integrally laminated superstrate construction of solar cell module body 4, as indicated by the partial enlarged view of edge portion 45 thereof shown in FIG. 10-wherein light-receiving-surface sealing resin layer(s) 42a comprising ethylene vinyl acetate (EVA), solar cell(s) 43 formed from polycrystalline silicon, back-surface sealing resin layer(s) 42b comprising ethylene vinyl acetate (EVA), and weather-resistant back-surface sealing film(s) 44 are laminated in order over (or beneath, as shown in the drawing) light-receiving glass surface(es) 41 constituting the front surface thereof-is known. This being the case, the solar cell module body 4 may take the form of a rectangular sheet and its weather-resistance may be assured. Note that the foregoing solar cell(s) 43 may be formed from monocrystalline silicon and/or amorphous silicon and/or the like.

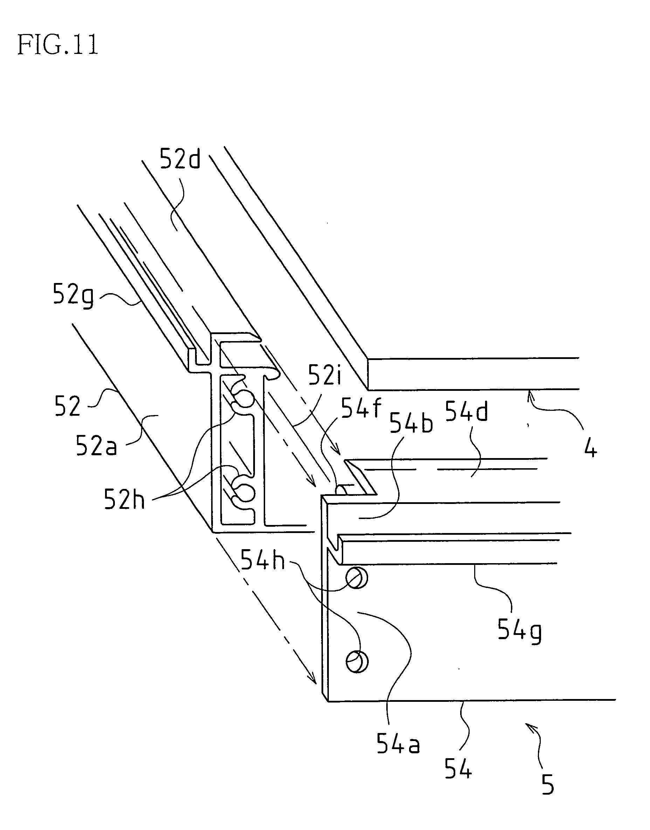

As shown in FIGS. 9 and 11 (the latter being an oblique exploded view of region III in FIG. 9), frame body 5-which retains the four sides of the foregoing solar cell module body 4-comprises upper frame element(s) 51, lower frame element(s) 52, and pair(s) of left and right side edge frame elements 53 and 54, these frame elements 51, 52, 53, and 54 being assembled together in integral fashion to form a frame-like structure. Note that FIG. 11 shows the region at which lower frame element 52 and right side edge frame element 54 are assembled together.

Frame elements 51, 52, 53, and 54 are respectively formed by aluminum extrusion. Upper frame element 51 retains the edge rim of solar cell module body 4 at the side thereof nearest the residence roof peak. Lower frame element 52 retains the edge rim of solar cell module body 4 at the side thereof nearest the residence eaves. Side edge frame elements 53 and 54 respectively retain both the left and the right side rim of solar cell module body 4, and also join together the two edge rims of upper frame element 51 and lower frame element 52.

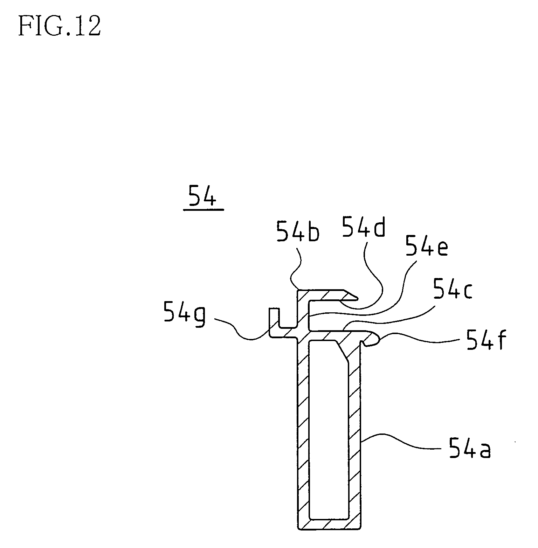

Next, basic constitution of these frame elements 51, 52, 53, and 54 will be described in detail. Because frame elements 51, 52, 53, and 54 share a common basic constitution, FIG. 12 will be used to describe cross-sectional shape of side edge frame element 54. Note that, in the description of cross-sectional shape which follows, the left side in FIG. 12 is taken to be the outside, constituting the outer rim of solar cell module 2; and the right side in the drawing is taken to be the inside, i.e., the side at which solar cell module body 4 is supported.

As shown in FIG. 12, side edge frame element 54 is provided with frame main body 54a having closed rectangular cross-section, and is also provided with bent extension region 54b which extends upward from the outside edge (left edge in the drawing) at the top face of this frame main body 54a and thereafter bends toward the inside (right side in the drawing). This permits formation of groove 54e, within which the outside perimeter edge portion of solar cell module body 4 is captured between horizontal portion 54d of bent extension region 54b and top face 54c of frame main body 54a. Furthermore, flange 54f, which abuts the bottom face of solar cell module body 4, is disposed so as to project from the inside edge (the edge on the right side in the drawing) of top face 54c of frame main body 54a. Note that the width dimension (the dimension in the vertical direction in FIG. 11) of this groove 54e is set so as to be slightly larger than the thickness dimension of solar cell module body 4.

Furthermore, disposed so as to project from the side face at the outside (left side in drawing) of frame main body 54a is extension 54g, which extends slightly in a horizontal direction before bending upward.

Note also that reference numeral 52h in FIG. 11 indicates screw-receiving portion(s), having screw channels(s), provided at lower frame element 52; and reference numeral 54h indicates screw clearance hole(s) which are provided at side rim frame element 54 opposite these screw-receiving portion(s) 52h.

However, with solar cell module 2 constituted in such fashion, because of the need to ensure adequate watertightness between solar cell module body 4 and frame body 5, and prevent rainwater or the like from entering through gaps therebetween, various methods for achieving watertightness have been proposed conventionally (see, e.g., Japanese Patent Application Publication Kokai No. 2001-230440 (FIG. 6 (a)).

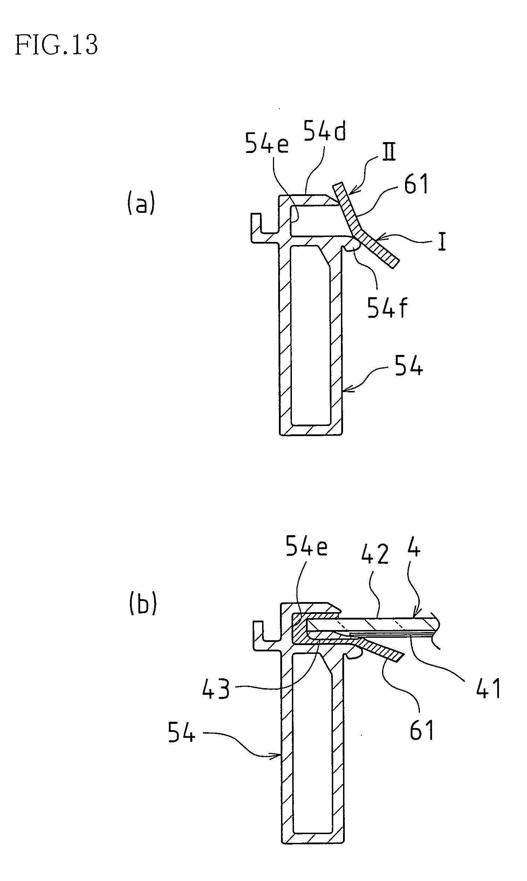

FIG. 13 shows an example of a conventional waterproofing structure for achieving watertightness between solar cell module body 4 and frame body 5, the structure being such that tape-like waterproofing member 61 is inserted in the space between solar cell module body 4 and frame body 5. That is, waterproofing member 61 is arranged so as to enshroud the open portion(s) of groove 54e of side edge frame element 54. This waterproofing member 61 is a sheet-like member formed from EPDM or other such foam material, and is disposed so as to straddle flange 54f from horizontal portion 54d of extension region 54b of side edge frame element 54. Furthermore, this waterproofing member 61 is made to adhere to the tip portion of this flange 54f (region I at FIG. 13 (a)). In other words, as waterproofing member 61 merely contacts, and is not securely fastened to, horizontal portion 54d of bent extension region 54b (region II at FIG. 13 (a)), this edge portion is in fact a free edge. Moreover, the thickness dimension of this waterproofing member 61 is set so as to be slightly larger than a dimension which is one half of the value obtained by subtracting the thickness dimension of solar cell module body 4 from the width dimension (the dimension in the vertical direction at FIG. 13 (a)) of groove 54e of side edge frame element 54. This waterproofing member 61 might for example be formed from butylene rubber.

While the foregoing description concerns itself with the manner in which waterproofmg member 61 is provided at one side edge frame element 54, waterproofing member(s) 61 is/are provided in like fashion at the other side edge frame element 53; and moreover, waterproofing member(s) 61 is/are provided in like fashion at upper frame element 51 and lower frame element 52.

This waterproofmg member 61 is captured by frame elements 51, 52, 53, and 54 at the same time that solar cell module body 4 is captured thereby. Here, description will be carried out taking operation with respect to how the side edge portion of solar cell module body 4 is captured within side edge frame element 54 to be representative of the others. To wit, when the side edge portion of solar cell module body 4 is captured within groove 54e of side edge frame element 54, waterproofing member 61 is deformed as a result of pressure from solar cell module body 4.

As shown at FIG. 13 (b), deformation of waterproofing member 61 is such that the free-edge side (the portion at the top at FIG. 13 (b)) of waterproofing member 61 is pressed by solar cell module body 4 against the interior of groove 54e, waterproofing member 61 being deformed so as to wrap around the outside perimeter portion of solar cell module body 4 in parallel fashion with respect to the inside surface of this groove 54e. Waterproofing member(s) 61 are therefore respectively present between the inside surface of groove 54e and the top surface and the bottom surface of the outside perimeter portion of solar cell module body 4. At this time, because, as mentioned above, the thickness dimension of waterproofing member 61 is set so as to be slightly larger than one half of the value obtained by subtracting the thickness dimension of solar cell module body 4 from the width dimension (the dimension in the vertical direction at FIG. 13 (b)) of groove 54e, waterproofing member 61 will upon completion of this capturing operation be compressed between the outside surface (at both the top and the bottom) of solar cell module body 4 and the inside surface of groove 54e.

Furthermore, the present inventors have already proposed a waterproofing methodology utilizing structure different from the waterproofing structure described at Japanese Patent Application Publication Kokai No. 2001-230440 (hereinafter "Proposed Technology"). More specifically, a structure may be adopted such that one or more edge face sealing members, frame-like in shape and formed in more or less parallel fashion with respect to one or more outer shapes of solar cell module body or bodies, is or are prepared; such edge face sealing member or members being captured within frame body or bodies and also capturing solar cell module body or bodies along substantially the entire edge portion perimeter of solar cell module body or bodies. To this end, edge face sealing member or members may be roughly c-shaped in cross-section, may comprise one or more upper sealing regions abutting one or more front surfaces of solar cell module body or bodies, may further comprise one or more lower sealing regions abutting one or more back surfaces of solar cell module body or bodies, and may further comprise one or more side sealing regions abutting one or more edge faces of solar cell module body or bodies. Such sealing member(s) were used to seal edge face(s) of solar cell module(s).

A waterproofing structure having the foregoing constitution will make it possible to ensure watertightness between solar cell module body 4 and the frame body 5 which supports same.

However, with the waterproofing structure of the foregoing Patent Reference No. 1, there has been the problem that because the structure is such that, simultaneous with capturing of the outside perimeter edge portion of solar cell module body 4 within groove 54e of frame body 5, tape-like waterproofing member 61 is progressively captured within groove 54e of frame body 5 as it is pressed thereinto, notwithstanding the fact that one of the rim portions of waterproofing member 61 may in fact have been made to adhere to the tip portion of flange 54f, the pressure of insertion can nonetheless cause waterproofing member 61 to slip, making it difficult to achieve a seal which is uniform along the entire perimeter edge portion of solar cell module body 4. Furthermore, there has been the problem that because the portion that has slipped and extends outside of the groove of the frame body necessitates postprocessing in which a worker uses a knife or the like to remove it, this has increased work operations.

Furthermore, there has also been the problem that because tape-like waterproofing member 61 must be bent as it is progressively pressed into the interior of groove 54e of frame body 5, this insertion operation is also complicated, making it troublesome and time-consuming.

Moreover, there has also been the problem that because waterproofing member 61 is bent unnaturally at the comer portion(s) of frame body 5, it has been necessary to have another waterproofing member made available for such portion(s), and it has been difficult to adequately ensure watertightness at especially the comer portion(s).

Furthermore, while the waterproofing structure of the foregoing Proposed Technology may provide adequate effect when the glass body of solar cell module body 4 is flat and smooth on the light-receiving side thereof, there is still the problem that when the glass surface is nonflat and/or nonsmooth it is possible for water to enter via nonflat and/or nonsmooth portions thereof. This is also true with respect to the waterproofing structure described at Japanese Patent Application Publication Kokai No. 2001-230440.

The present invention was conceived in order to solve such problems, it being an object thereof to provide a solar cell module edge face sealing member and a solar cell module employing same which will provide watertightness (i.e., sealing) through a simple structure designed to facilitate operations during solar cell module assembly.

### SUMMARY OF INVENTION

One or more embodiments of the present invention is or are predicated upon a solar cell module construction which is such that one or more solar cell module bodies are captured within one or more frame bodies. In addition, a structure may be adopted such that edge face sealing member(s), being frame-like in shape and formed in more or less parallel fashion with respect to outer shape(s) of solar cell module body or bodies and/or being formed in such shape as to more or less conform to respective sides of solar cell module body or bodies, is or are prepared; such edge face sealing member(s) being captured within frame body or bodies so as to be captured thereby along substantially entire edge portion perimeter(s) of solar cell module body or bodies.

To this end, the edge face sealing member(s) may be roughly c-shaped in cross-section, may comprise upper sealing region(s) abutting front surface(s) of the solar cell module body or bodies, may further comprise lower sealing region(s) abutting back surface(s) of the solar cell module body or bodies, and may further comprise side sealing region(s) abutting edge face(s) of the solar cell module body or bodies; and moreover, the edge face sealing member(s) may be of two-layer construction, outer layer member(s) being hard, and hardness(es) of inner layer member(s) being less than that of outer layer member(s). This makes it possible for there to be intimate contact even with nonflat and/or nonsmooth glass surface(s), permitting sealing.

In such case, the edge face sealing member(s) may be such that the lower sealing region(s) is/are longer than the upper sealing region(s). The lower sealing region(s) being the portion(s) abutting back surface(s) of the solar cell module body or bodies, the edge face sealing member(s) can be prevented from easily falling out of the solar cell module body or bodies. Furthermore, the shape of the frame body may be similar to the shape of the frame body shown in FIG. 12; in which case, as shown in FIG. 12, because flange 54f, being the portion abutting the lower sealing region(s), is longer than horizontal portion 54d of bent extension region 54b abutting the lower sealing region(s), forming same such that its length matches that of this horizontal portion 54d will also be preferred from the standpoint of watertightness.

Furthermore, projection(s) for preventing the inner layer member(s) from emerging from the outer layer member(s) may be formed at the upper sealing region(s) and at the lower sealing region(s). With perimeter edge portion(s) of the solar cell module body or bodies captured by sealing member(s) (i.e., the edge face sealing member(s)), when such sealing member portion(s) are captured within groove(s) of the frame body or bodies, presence of such projection(s) makes it possible for the sealing member(s) to be compressed by groove(s) of the frame body or bodies and for intimate contact to be produced therebetween, as a result of which definitive sealing is permitted even with nonflat and/or nonsmooth glass surface(s).

Moreover, still more benefit may be obtained where such sealing structure is applied to solar cell module body or bodies of integrally laminated superstrate construction such that laminated in order over one or more nonflat and/or nonsmooth light-receiving glass surfaces constituting one or more front surfaces there are one or more light-receiving-surface sealing resin layers comprising ethylene vinyl acetate, one or more solar cells, one or more back-surface sealing resin layers comprising ethylene vinyl acetate, and one or more weather-resistant back-surface sealing films. Note however that the present invention is not limited to application in the context of superstrate structures, it also being possible to apply same for example to see-through-type solar cell modules wherein both the top and bottom surfaces are formed from glass.

As described above, one or more embodiments of the present invention is/are predicated upon a situation in which the solar cell module construction is such that the solar cell module body or bodies is/are captured within the frame body or bodies. In addition, a structure may be adopted such that the edge face sealing member(s), of two-layer construction and being frame-like in shape and formed in more or less parallel fashion with respect to outer shape(s) of the solar cell module body or bodies and/or being formed in such shape as to more or less conform to respective sides of the solar cell module body or bodies, is or are prepared; such edge face sealing member(s) being captured within the frame body or bodies so as to be captured thereby along substantially entire edge portion perimeter(s) of the solar cell module body or bodies. Because a construction is thus adopted in which the frame-shaped, integral-type edge face sealing member(s) and/or the edge face sealing member(s) of such shape as to more or less conform to respective sides of the solar cell module body or bodies is/are captured along substantially entire edge portion perimeter(s) of the solar cell module body or bodies, intimate contact and definitive sealing is permitted, permitting definitive prevention of entry by water, even where the solar cell module body or bodies is/are such that the light-receiving glass body or bodies is/are nonflat and/or nonsmooth on the light-receiving side thereof.

Furthermore, because the edge face sealing member(s) which is or are c-shaped and/or u-shaped in cross-section is or are made to capture the solar cell module body or bodies, and while in this state, these are then caused to be captured by the frame body or bodies, it is possible to rest assured that the edge face sealing member(s) will not slip when caused to be captured by the frame body or bodies, and moreover, ease of operations with respect to the capturing step is improved.

Furthermore, causing the lower sealing region(s) of the edge face sealing member(s) to be formed so as to be longer than the upper sealing region(s) thereof makes it possible to prevent the edge face sealing member(s) from easily falling out of the solar cell module body or bodies, and also improves watertightness at the back surface of the solar cell module body or bodies.

Furthermore, when such edge face sealing member(s) are captured within groove(s) of the frame body or bodies, because presence of the projection(s) on facing surface(s) of the upper sealing region(s) and the lower sealing region(s) makes it possible for the edge face sealing member(s) to be compressed by groove(s) of the frame body or bodies and for the projection(s) to be squashed by top surface(s) and bottom surface(s) of the solar cell module body or bodies, producing intimate contact therebetween, definitive sealing of edge face(s) of the solar cell module body or bodies is permitted. Moreover, by disposing tip portion(s) of the upper sealing region(s) and the lower sealing region(s) so as to incline toward recess(es), because tip portion(s) of the upper sealing region(s) and the lower sealing region(s) can also be made to press against top surface(s) and bottom surface(s) of the solar cell module body or bodies, producing intimate contact therebetween, synergistic operation in combination with the projection(s) permits more definitive sealing of edge face(s) of the solar cell module body or bodies.

### BRIEF DESCRIPTION OF DRAWINGS

FIG. 1 is an oblique view of the entirety of an edge face sealing member associated with a first embodiment of the present invention.

FIG. 2 is a cross-sectional view of section D-D in FIG. 1.

FIG. 3 (a) is a partial enlarged sectional view showing how an edge face sealing member of the first embodiment captures an edge portion of a solar cell module body, and FIG. 3 (b) is a partial enlarged sectional view showing how the edge portion of the solar cell module body as shown at FIG. 3 (a) is captured within a groove of a frame body.

FIG. 4 is a sectional view of an edge face sealing member associated with a second embodiment of the present invention.

FIG. 5 is a partial enlarged sectional view showing, where an edge portion of a solar cell module body is captured by an edge face sealing member, how this is moreover captured by a groove of a frame body.

FIG. 6 is a sectional view of an edge face sealing member associated with a third embodiment of the present invention.

FIG. 7 is a sectional view of an edge face sealing member associated with a fourth embodiment of the present invention.

FIG. 8 is a sectional view of an edge face sealing member associated with a fifth embodiment of the present invention.

FIG. 9 (a) is a plan view of a solar cell module. FIG. 9 (b) shows the view from arrow B at FIG. 9 (a). FIG. 9 (c) shows the view from arrow C at FIG. 9 (a).

FIG. 10 is a partial enlarged sectional view showing an edge portion of solar cell module body of superstrate construction.

FIG. 11 is an oblique exploded view of region III in FIG. 9.

FIG. 12 is a sectional view of a frame body.

FIG. 13 (a) is a sectional view showing arrangement of a conventional waterproofing member. FIG. 13 (b) is a sectional view showing deformation of a conventional waterproofing member.

### DESCRIPTION OF PREFERRED EMBODIMENTS

Below, embodiments of the present invention are described with reference to the drawings.

### FIRST EMBODIMENT

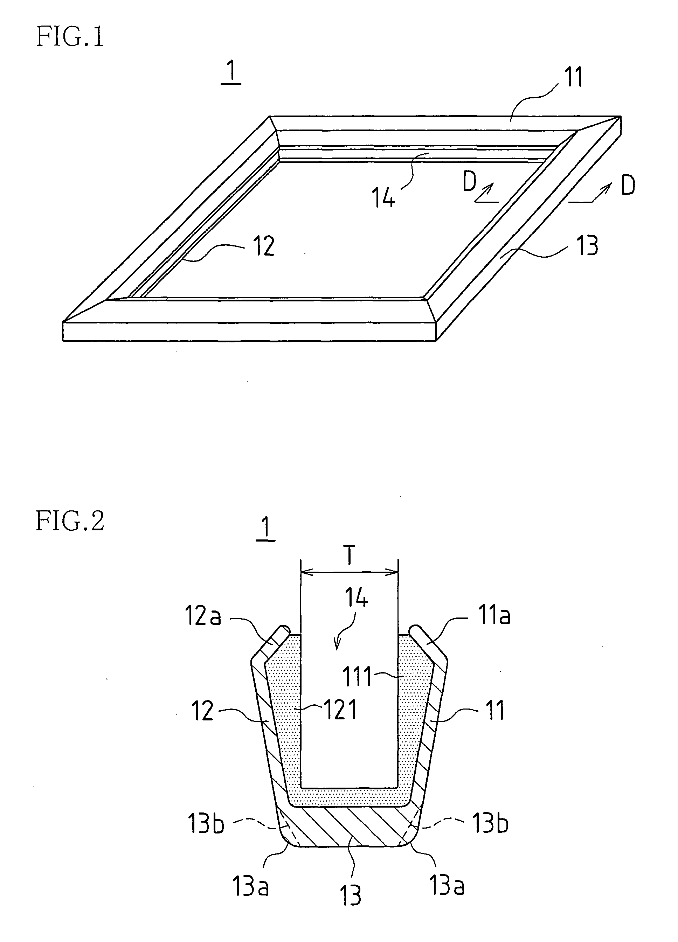

[FIG. 1 is an oblique view of the entirety of an edge face sealing member 1 associated with a first embodiment of the present invention, and FIG. 2 is a cross-sectional view of section D-D in FIG. 1. Note that, in the present first embodiment, the description below is carried out in terms of a solar cell module body employing superstrate structure such as that of solar cell module body 4 shown in FIG. 10, and in terms of a frame body employing structure such as that of frame body 5 shown in FIG. 12.

This edge face sealing member 1, which is frame-like in shape and is formed in more or less parallel fashion with respect to the outer shape of solar cell module body 4 shown in FIG. 10, is captured by frames 51, 52, 53, and 54 of frame body 5 shown in FIG. 9 so as to be captured thereby along substantially the entire perimeter of edge portion 45 (see FIG. 10) of solar cell module body 4.

As shown in FIG. 2, this edge face sealing member 1 is roughly c-shaped in cross-section and/or roughly u-shaped in cross-section; is of two-layer construction; and comprises upper sealing region 11 abutting nonflat and/or nonsmooth light-receiving glass surface 41 which constitutes the front surface of solar cell module body 4, lower sealing region 12 abutting weather-resistant back-surface sealing film 44 of solar cell module body 4, and side sealing region 13 abutting edge face 45a (see FIG. 10) of solar cell module body 4. This upper sealing region 11, this lower sealing region 12, and this side sealing region 13 form groove recess 14 which captures edge portion 45 of solar cell module body 4.

Furthermore, upper sealing region 11 and lower sealing region 12 are disposed so as to open somewhat to the outside therefrom at either side from respective edge portions 13a, 13a of side sealing region 13, and respective tip portions 11a and 12a are formed in bent fashion so as to be inclined toward each other, i.e., toward groove recess 14. Distance T between these two tip portions 11a and 12a is roughly the same as or is somewhat less than the thickness of edge portion 45 of solar cell module body 4. Furthermore, respective edge portions 13a, 13a of side sealing region 13 are formed so as to be curved in order to facilitate capture thereof by frame body 5. Moreover, as indicated by the broken line in FIG. 2, diagonal cuts may be made therein so as to produce chamfered surfaces 13b, 13b.

Respective sealing regions 11, 12, 13 of edge face sealing member 1, being formed in such manner, are constructed of multiple layers of members having mutually different hardnesses (two-layer construction in the present first embodiment). That is, formed to the interior of respective sealing regions 11, 12, 13 making up the outer layer are inner layer members 111, 121, 131 having hardnesses less than hardnesses of respective sealing regions 11, 12, 13 and permitting intimate contact to exist even with nonflat and/or nonsmooth surface(s).

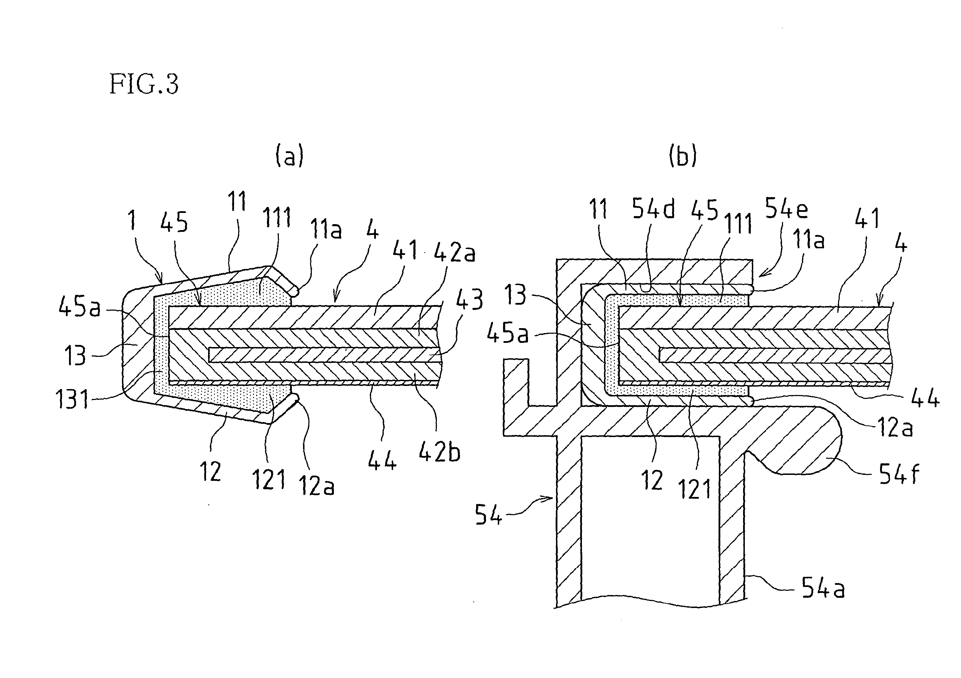

FIG. 3 (a) shows how edge face sealing member 1, constituted as described above, captures edge portion 45 of solar cell module body 4.

In this state, inner layer members 111 and 121 abut light-receiving glass surface 41 and weather-resistant back-surface sealing film 44 of solar cell module body 4; and respective tip portions 11a and 12a of upper sealing region 11 and lower sealing region 12 contact light-receiving glass surface 41 and weather-resistant back-surface sealing film 44 of solar cell module body 4 such that they are somewhat compressed thereagainst and possess force sufficient to retain edge portion 45 of solar cell module body 4. Due to this fact, it is possible to rest assured that edge face sealing member 1 will not easily slip off of edge portion 45 of solar cell module body 4.

With these in this state, upon causing edge portion 45 of solar cell module body 4 to be captured by groove 54e of frame body 5, edge face sealing member 1 is deformed in parallel fashion with respect to the inside surface of groove 54e as shown at FIG. 3 (b), respective inner layer members 111 and 121 (not shown) at upper sealing region 11 and lower sealing region 12, and respective tip portions 11a and 12a of upper sealing region 11 and lower sealing region 12, being squashed and coming into intimate contact with nonflat and/or nonsmooth light-receiving glass surface 41 and weather-resistant back-surface sealing film 44 of solar cell module body 4. At this time, moreover, inner layer member 131 at side sealing region 13 of edge face sealing member 1 likewise comes in intimate contact with edge face 45a of solar cell module body 4, and edge face 45a of solar cell module body 4 is completely sealed.

### SECOND EMBODIMENT

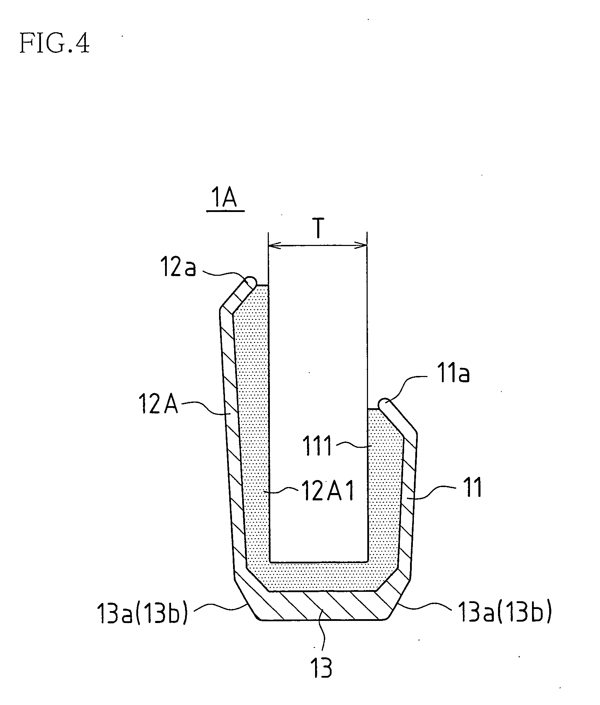

FIG. 4 is a sectional view of edge face sealing member 1A associated with a second embodiment of the present invention.

Edge face sealing member 1A of the present second embodiment differs from edge face sealing member 1 of the foregoing first embodiment in that lower sealing region 12A abutting weather-resistant back-surface sealing film 44 of solar cell module body 4 is formed so as to be longer than upper sealing region 11 abutting light-receiving glass surface 41 of solar cell module body 4, the constitution thereof being in other respects similar to that of edge face sealing member 1 of the foregoing first embodiment. Accordingly, where components are identical to those at edge face sealing member 1 of the first embodiment, identical reference numerals will be used and detailed description thereof will be omitted.

The reason for thus forming lower sealing region 12A such that it is longer than upper sealing region 11 is that, as shown in FIG. 12, flange 54f is provided at the inside edge of top face 54c of frame main body 54a, and this surface is longer than horizontal portion 54d of bent extension region 54b by an amount corresponding to this flange 54f. Lower sealing region 12A is therefore formed such that the length thereof more or less matches the length from the basal edge portion of top face 54c (the region at which it is connected to bent extension region 54b) to the tip of flange 54f.

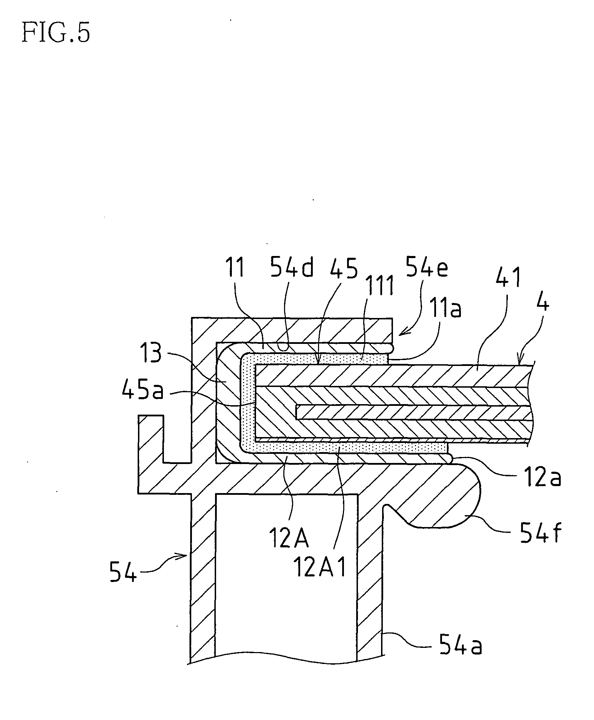

FIG. 5 shows how, where edge portion 45 of solar cell module body 4 is captured by edge face sealing member 1A constituted as described above, this is moreover captured by frame body 5.

With these in this state, edge face sealing member 1 is deformed in parallel fashion with respect to the inside surface of groove 54e of frame body 5, and respective inner layer members 111 and 12A1 (not shown) at upper sealing region 11 and lower sealing region 12A, and respective tip portions 11a and 12a of upper sealing region 11 and lower sealing region 12A, are squashed and come into intimate contact with light-receiving glass surface 41 and weather-resistant back-surface sealing film 44 of solar cell module body 4. In such case, because lower sealing region 12A is brought into intimate contact therewith over the entirety, more or less, of flange 54f and top face 54c of groove 54e, watertightness at the back surface of solar cell module body 4 is improved. At this time, moreover, inner layer member 131 (not shown) at side sealing region 13 of edge face sealing member 1 likewise comes in intimate contact with edge face 45a of solar cell module body 4, and edge face 45a of solar cell module body 4 is completely sealed.

Note also that because, as shown in FIG. 10, solar cell module body 4, which is of superstrate construction, is such that, in contrast to light-receiving glass surface 41 at the front surface thereof, the back surface thereof is thin weather-resistant film 44, where integral lamination is carried out the back surface will be forcibly pulled upon such that it becomes somewhat inclined. When lower sealing region 12A is made long as in the present second embodiment, this will also have the advantage that it will be possible to cause edge portion 45 of solar cell module body 4 to be definitively captured by edge face sealing member 1A, any such inclination having little effect thereon. Or stating this conversely, this has the benefit of also preventing edge face sealing member 1A from slipping off of solar cell module body 4.

### THIRD EMBODIMENT

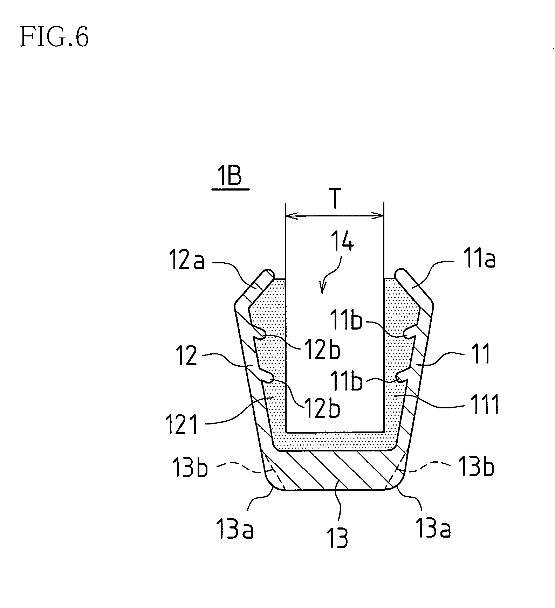

FIG. 6 is a sectional view of edge face sealing member 1B associated with a third embodiment of the present invention.

Edge face sealing member 1B of the present third embodiment differs from edge face sealing member 1 of the foregoing first embodiment in that proj ections 11b and 12b are respectively formed on facing surfaces of upper sealing region 11 and lower sealing region 12, the constitution thereof being in other respects similar to that of edge face sealing member 1 of the foregoing first embodiment. Accordingly, where components are identical to those at edge face sealing member 1 of the first embodiment, identical reference numerals will be used and detailed description thereof will be omitted.

These projections 11b, 12b may take the form of single-rib and/or multiple-rib regions (two ribs being formed in the present third embodiment) formed in more or less parallel fashion with respect to perimeter edge portions (sides) of solar cell module body 4, i.e., in more or less parallel fashion with respect to the long direction of groove recess 14. Furthermore, respective inner layer members 111, 121 at upper sealing region 11 and lower sealing region 12 are also disposed so as to cover these projections 11b, 12b. That is, proj ections 11b, 12b are formed so as to prevent inner layer members 111, 121 from emerging from upper sealing region 11 and lower sealing region 12, these constituting outer layer members. With perimeter edge portion(s) of solar cell module body 4 captured by edge face sealing member 1B, when this edge face sealing member 1B is captured within groove 54e of frame body 5, presence of such projections 11b, 12b makes it possible for edge face sealing member 1B to be compressed by groove 54e of frame body 5 and for intimate contact to be produced therebetween, as a result of which definitive sealing is permitted even where glass surface(s) of light-receiving glass surface 41 is/are nonflat and/or nonsmooth.

### FOURTH EMBODIMENT

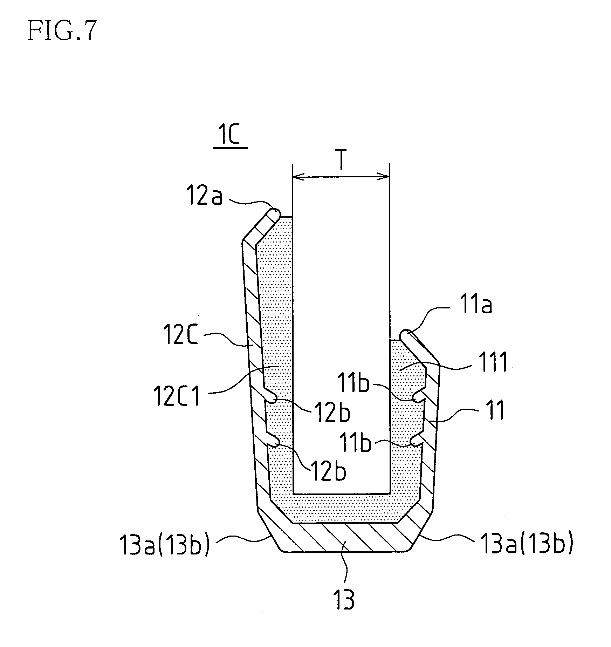

FIG. 7 is a sectional view of edge face sealing member 1 C associated with a fourth embodiment of the present invention.

Edge face sealing member 1C of the present fourth embodiment differs from edge face sealing member 1A of the foregoing second embodiment in that projections 11b and 12b are respectively formed on facing surfaces of upper sealing region 11 and lower sealing region 12, the constitution thereof being in other respects similar to that of edge face sealing member 1A of the foregoing second embodiment. Accordingly, where components are identical to those at edge face sealing member 1A of the second embodiment, identical reference numerals will be used and detailed description thereof will be omitted.

These projections 11b, 12b may take the form of single-rib and/or multiple-rib regions (two ribs being formed in the present fourth embodiment) formed in more or less parallel fashion with respect to perimeter edge portions (sides) of solar cell module body 4, i.e., in more or less parallel fashion with respect to the long direction of groove recess 14. Furthermore, respective inner layer members 111, 12C1 at upper sealing region 11 and lower sealing region 12 are also disposed so as to cover these projections 11b, 12b. That is, projections 11b, 12b are formed so as to prevent inner layer members 111, 12C1 from emerging from upper sealing region 11 and lower sealing region 12, these constituting outer layer members. With perimeter edge portion(s) of solar cell module body 4 captured by edge face sealing member 1C, when this edge face sealing member 1C is captured within groove 54e of frame body 5, presence of such projections 11b, 12b makes it possible for edge face sealing member 1C to be compressed by groove 54e of frame body 5 and for intimate contact to be produced therebetween, as a result of which definitive sealing is permitted even where glass surface(s) of light-receiving glass surface 41 is/are nonflat and/or nonsmooth.

### FIFTH EMBODIMENT

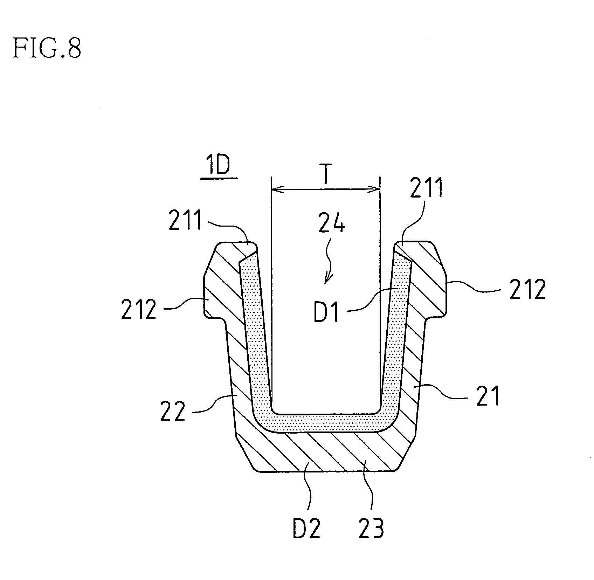

FIG. 8 is a sectional view of edge face sealing member 1D associated with a fifth embodiment of the present invention.

As shown in FIG. 8, edge face sealing member 1D of the present fifth embodiment is constructed from two layers-inner layer member D1 and outer layer member D2-having mutually different hardnesses and formed so as to be roughly c-shaped in cross-section and/or roughly u-shaped in cross-section, and comprises upper sealing region 21 abutting nonflat and/or nonsmooth light-receiving glass surface 41 which constitutes the front surface of solar cell module body 4; lower sealing region 22 abutting weather-resistant back-surface sealing film 44 of solar cell module body 4; and side sealing region 23 abutting edge face 45a (see FIG. 10) of solar cell module body 4. This upper sealing region 21, this lower sealing region 22, and this side sealing region 23 form groove recess 24 which captures edge portion 45 of solar cell module body 4.

Respective sealing regions 21, 22, 23 of edge face sealing member 1D, being formed in such manner, are, as described above, constructed from two layers-inner layer member D1 and outer layer member D2-having mutually different hardnesses; such that, formed to the interior of outer layer member D2 is inner layer member D1 having hardness less than the hardness of outer layer member D2 and permitting intimate contact to exist even with nonflat and/or nonsmooth surface(s).

Furthermore, formed at free tip portions of outer layer member D2 are first projections 211 which mutually protrude in directions such as will receive tip portions of inner layer member D1, i.e., so as to be directed toward groove recess 24; and formed on outside surface(s) of the free tip portions are second projections 212 which protrude outward.

Here, at edge face sealing member 1D of the present fifth embodiment, the inside surface of groove recess 24 forms a channel that is wider than the thickness of edge portion 45 of solar cell module body 4; more particularly, this channel is formed such that the width thereof gradually increases as one goes from the floor of groove recess 24 to the free tip portions thereof. Moreover, this channel is formed such that the width T at the floor thereof is approximately equal to the thickness (width) of edge portion 45 of solar cell module body 4.

By thus shaping the inside surface of groove recess 24 so as to form a channel that is wider than the thickness (width) of edge portion 45 of solar cell module body 4, operations in which this edge face sealing member 1D is made to capture edge portion 45 of solar cell module body 4 are facilitated. That is, when this edge face sealing member 1D is made to capture edge portion 45 of solar cell module body 4, because capturing operations can be carried out without causing soft inner layer member D1 of edge face sealing member 1D to be compressed by edge portion 45 of solar cell module body 4, it is possible during capturing operations to prevent inner layer member D1 from being deformed as a result of being stretched and/or squashed in the capturing direction (i.e., in direction(s) parallel to the light-receiving surface of solar cell module body 4). In addition, not only is edge face sealing member 1D made to simply capture solar cell module body 4, but by causing the slightly open shape thereof to conform to solar cell module body 4 it is possible to cause inner layer member D1 to press against light-receiving glass surface 41 of solar cell module body 4 such that there is transfer of surface profile thereto and intimate contact therebetween.

First projections 211 are provided in order to prevent the soft inner layer member D1 from being stretched and/or squashed in direction(s) parallel to the light-receiving surface of solar cell module body 4 as a result of being pressed against by frame body 5 in direction(s) perpendicular to the light-receiving surface of solar cell module body 4 after edge face sealing member 1D captures peripheral portion(s) of solar cell module body 4 and is inserted in frame body 5. One purpose of this is to cause complete transfer of the surface profile of the light-receiving surface of solar cell module body 4 to the soft inner layer member D1 such that there is intimate contact therebetween. Furthermore, as a result of valve-like action at the bottom surface of solar cell module body 4 (i.e., the surface on the opposite side as the light-receiving surface thereof), watertightness at both surfaces is increased.

Second projections 212, having reactive force due to mechanical strength of frame body 5 after edge face sealing member 1D has been completely inserted within frame body 5, are provided in order to impart compliance for assisting in maintaining contact between inner layer member D1 and solar cell module body 4. This being the case, these are not limited to the shape shown in FIG. 8, there being no objection to employment of any arbitrary protruding shape so long as it has the effect of functioning to press against inner layer member D1. Here, the reason that cross-sectional shape is made to have bilateral symmetry is to facilitate operations, handling being simplified to the extent that edge face sealing member 1D lacks directionality. With perimeter edge portion(s) of solar cell module body 4 captured by edge face sealing member 1D, when this edge face sealing member 1D is captured within groove(s) of frame body 5, employment of elastomers in a construction made up of two layers having different hardnesses together with inner and outer projections and utilizing such cross-sectional shape as basis thereof makes it possible for particularly inner layer member D1 of edge face sealing member 1D to be compressed by groove(s) of frame body 5 and second projections 212 of edge face sealing member 1D, and for intimate contact to be produced therebetween. This makes it possible to achieve definitive sealing regardless of the condition of the glass surface(s).

Next, description is carried out with respect to materials employed at edge face sealing members 1, 1A, 1B, 1C, 1D of the foregoing first through fifth embodiments.

It is preferred that material(s) making up edge face sealing members 1, 1A, 1B, 1C, 1D be polypropylenic and/or polystyrenic elastomer resin(s) and/or silicone resin(s). More specifically, it is still more preferred that PP-EPDM (polypropylene - ethylene propylene diene copolymeric synthetic rubber) copolymer be for example employed as polypropylenic elastomer resin(s), and/or that polystyrene - isoprene copolymer be for example employed as polystyrenic elastomer resin(s). Polypropylenic and polystyrenic elastomer resins possess characteristics such as lightness in weight due to low specific gravity, manufacturability and recyclability, designability with respect to coloration, weather resistance (retention of physical properties over long periods), sealability, aging as a result of heat, flexibility at low temperature (-40° C), dimensional stability of extruded product, flexibility with respect to design of cross-section of extruded product, thermal deposition, and so forth. Because complicated operations are not necessary such as is the case with vulcanized rubber, it being possible to easily carry out extrusion molding in the same manner as with ordinary plastics, such resins are suitable for use where precise cross-sectional dimensions are required, as is the case with the sealing material for the solar cell module body of the present invention.

Furthermore, silicone resin(s) is/are also favorably used as material(s) making up edge face sealing members 1, 1A, 1B, 1C, 1D. This is because silicone resins possess characteristics such as manufacturability, designability with respect to coloration, weather resistance (retention of physical properties over long periods), sealability, aging as a result of heat, and so forth. More specifically, uncrosslinked silicone resin(s) and/or partially crosslinked silicone resin(s) may be used at the soft side thereof which comes in contact with the solar cell module body. Where such silicone resin(s) is/are uncrosslinked, plastic deformation of silicone resin(s) when implemented in embodiment(s) as described above will make it possible for solar cell module light-receiving surface shape(s) to be directly accommodated by and transferred to edge face sealing member(s) such that edge face sealing member(s) take on shape(s) of solar cell module light-receiving surface(s), producing intimate contact therebetween and making it possible to inhibit entry of contaminant(s) and seal solar cell(s). Furthermore, where partially crosslinked silicone resin(s) is/are used, this might be done not only for plastic deformation but alternatively or additionally where compliance is desired in material(s) so as to make it possible, when intimate contact and sealing has been achieved, to permit such contact to be maintained despite application of load(s) to solar cell module(s) due to changes in external environment.

On the other hand, crosslinked silicone resin(s) may be used at the opposite side thereof; i.e., at the hard side thereof which comes in contact with frame body 5. As its/their surface tack is low, crosslinked silicone resin(s) is/are employed primarily with the object of improving extrusion molding characteristics and/or manufacturability, such as where two-shot molding and/or adhesion with respect to uncrosslinked and/or partially crosslinked silicone resin(s) employed at the inner layer is to be achieved. Furthermore, because crosslinked silicone resin(s) excel in elasticity, when frame body 5 is used to seal edge face(s) of solar cell module body 4, through utilization of the reactive force therefrom it/they can also function to press uncrosslinked and/or partially crosslinked silicone resin(s) against solar cell(s). In order to accomplish such function, a configuration such as that shown in FIG. 8 might be adopted. Furthermore, because use of material(s) exhibiting such plastic deformation and/or elastic compliance makes it possible to achieve watertightness (sealing) not at side(s) but at surface(s), edge face sealing member(s) need not necessarily be frame-like in shape but may be applied in correspondence to respective side(s). Moreover, to improve weather resistance it is desirable that molding be carried out with admixture of carbon black thereinto.

Furthermore, as material(s) used for the outer layer (the side which comes in contact with frame body 5) in the present invention, it is preferred, in order to maintain strength of member(s) and in order to prevent center portion(s) of member(s) from drooping under its/their own weight when solar cell module side(s) being sealed thereby is/are long, that material(s) of hardness not less than 70 (Shore A) be employed. Moreover, as material(s) used for the inner layer (the side which comes in contact with edge face(s) of solar cell module body 4) in the present invention, it is preferred for watertightness at nonflat and/or nonsmooth surface(s) that material(s) be employed which is/are of hardness not more than 40 (Shore A); which is/are of hardness such as will permit plastic deformation in such fashion as to accommodate light-receiving glass surface shape; and/or which is/are of hardness such as will, when pressed against light-receiving glass surface(s), permit plastic deformation in such fashion as to accommodate light-receiving glass surface shape while maintaining elasticity (resilience) in the direction in which pressed thereagainst.

Moreover, the present invention may be embodied in a wide variety of forms other than those presented herein without departing from the spirit or essential characteristics thereof. The foregoing embodiments and working examples, therefore, are in all respects merely illustrative and are not to be construed in limiting fashion. The scope of the present invention being as indicated by the claims, it is not to be constrained in any way whatsoever by the body of the specification. All modifications and changes within the range of equivalents of the claims are, moreover, within the scope of the present invention.

## Claims

1. A solar cell module edge face sealing member constructed such that one or more solar cell module bodies is or are captured within one or more frame bodies, the edge face sealing member:
being frame-like in shape and formed in more or less parallel fashion with respect to one or more outer shapes of at least one of the solar cell module body or bodies and/or being formed in such shape as to more or less conform to respective sides of at least one of the solar cell module body or bodies;
being captured within at least one of the frame body or bodies so as to be captured thereby along substantially the entire edge portion perimeter of at least one of the solar cell module body or bodies; and
being constructed of multiple layers of members having mutually different hardnesses.

2. A solar cell module edge face sealing member according to claim 1 wherein the edge face sealing member:
is roughly c-shaped in cross-section;
comprises one or more upper sealing regions abutting one or more front surfaces of at least one of the solar cell module body or bodies;
further comprises one or more lower sealing regions abutting one or more back surfaces of at least one of the solar cell module body or bodies; and
further comprises one or more side sealing regions abutting one or more edge faces of at least one of the solar cell module body or bodies.

3. A solar cell module edge face sealing member according to claim 2 wherein the edge face sealing member:
is of two-layer construction;
one or more outer layer members being hard; and
at least one hardness of at least one inner layer member being less than that of at least one of the outer layer member or members.

4. A solar cell module edge face sealing member according to claim 3 wherein at least one of the inner layer member or members of the edge face sealing member is shorter than at least one of the outer layer member or members thereof.

5. A solar cell module edge face sealing member according to claim 2 or 3 wherein:
at least one surface of at least one of the outer layer member or members in at least one of the upper sealing region or regions and at least one surface of at least one of the outer layer member or members in at least one of the lower sealing region or regions face each other; and
at least one projection is formed on at least one of the mutually facing surfaces.

6. A solar cell module edge face sealing member according to claim 4 wherein at least one of the inner layer member or members is formed to the interior of at least one of the projection or projections at at least one of the outer layer member or members.

7. A solar cell module edge face sealing member according to claim 1 wherein at least one of the solar cell module body or bodies is of integrally laminated superstrate construction such that laminated in order over one or more light-receiving glass bodies constituting one or more front surfaces there are:
one or more light-receiving-surface sealing resin layers comprising ethylene vinyl acetate;
one or more solar cells;
one or more back-surface sealing resin layers comprising ethylene vinyl acetate; and
one or more weather-resistant back-surface sealing films;
at least one of the light-receiving glass body or bodies being nonflat and/or nonsmooth on the light-receiving side thereof.

8. A solar cell module edge face sealing member according to claim 7 wherein at least one elastomer resin and/or at least one silicone resin is used as at least one material making up the edge face sealing member.

9. A solar cell module constructed such that one or more solar cell module bodies is or are captured within one or more frame bodies, wherein at least one edge face sealing member:
being frame-like in shape and formed in more or less parallel fashion with respect to one or more outer shapes of at least one of the solar cell module body or bodies and/or being formed in such shape as to more or less conform to respective sides of at least one of the solar cell module body or bodies;
is captured within at least one of the frame body or bodies so as to be captured thereby along substantially the entire edge portion perimeter of at least one of the solar cell module body or bodies; and
is constructed of multiple layers of members having mutually different hardnesses.

10. A solar cell module according to claim 9 wherein at least one of the solar cell module body or bodies is of integrally laminated superstrate construction such that laminated in order over one or more light-receiving glass bodies constituting one or more front surfaces there are:
one or more light-receiving-surface sealing resin layers comprising ethylene vinyl acetate;
one or more solar cells;
one or more back-surface sealing resin layers comprising ethylene vinyl acetate; and
one or more weather-resistant back-surface sealing films;
at least one of the light-receiving glass body or bodies being nonflat and/or nonsmooth on the light-receiving side thereof.
